# EUROPÄISCHE PATENTSCHRIFT

(11) **EP 2 430 711 B1**
(45) Veröffentlichungstag und Bekanntmachung des Hinweises auf die Patenterteilung: **09.01.2013**
(21) Anmeldenummer: 10717065.6
(22) Anmeldetag: 29.04.2010
(51) Int. Cl.: H01R 13/648, H05K 9/00

(54) **HAFTVERSCHLUSSELEMENT**
HOOK AND LOOP FASTENER ELEMENT
ÉLÉMENT DE FERMETURE ADHÉSIVE

(30) Priorität: 13.05.2009 DE 102009020944
(43) Veröffentlichungstag der Anmeldung: 21.03.2012
(73) Patentinhaber: Gottlieb Binder GmbH & Co. KG, 71088 Holzgerlingen (DE)
(72) Erfinder: POULAKIS, Konstantinos, 71157 Hildrizhausen (DE)
(74) Vertreter: Bartels, Martin Erich Arthur
(86) Internationale Anmeldenummer: PCT/EP2010/002633
(87) Internationale Veröffentlichungsnummer: WO 2010/130338

(56) Entgegenhaltungen:
- WO-A1-2005/025362

## Beschreibung

Die Erfindung betrifft ein Haftverschlusselement mit einem elektrisch nicht leitenden, vorzugsweise aus einem Kunststoffmaterial gebildeten Träger, der eine Haftfläche definiert, aus der sich Haftelemente erstrecken, die für die Bildung eines Haftverschlusses mit Gegenelementen verhakbar sind, wobei innerhalb der Haftfläche mindestens ein elektrischer Leiterdraht vorhanden ist.

Ein gattungsgemäßes Haftverschlusselement ist aus DE 10 2006 039 134 A1 bekannt geworden. Es wird hier eine elektrische Kontaktanordnung mit einer Klettverbindung angegeben, die eine elektrisch leitfähige Oberfläche aufweist. Die Kontaktanordnung umfasst mindestens zwei Kontaktelemente mit jeweils einem biegsamen Trägerband, das einen Kontaktbereich mit Klettstrukturen aufweist, die zur Bildung der Klettverbindung miteinander verhakbar sind, und eine elektrische Verbindung ohne großen technischen Aufwand herstellen. Eine Leiterbahn ist in einem Zuleitungsbereich des jeweiligen Trägerbandes angeordnet, der vorzugsweise auf der Hauptfläche des jeweiligen Trägerbandes liegt, auf der auch der Kontaktbereich mit den Klettstrukturen angeordnet ist, und vorzugsweise frei von Klettstrukturen ist. Die Klettstrukturen von zwei Trägerbändern sind komplementär zueinander - als Schlaufen und Haken - aus einem Metalldraht ausgebildet und greifen bei einer Aneinanderlage ineinander. Alternativ umfassen die Klettstrukturen eine dünne Kunststofffaser mit einer metallisierten Oberfläche.

WO 2005/025362 A1 betrifft einen weiteren elektrisch leitfähigen Klettverschluss auf Basis von leitfähigen Polymeren. Der Klettverschluss enthält leitfähige Polymere und/oder Kunststoffcomposites, die mit leitfähigen Materialien gefüllt sind. Hochleitfähige Polymere, wie beispielsweise Poly-(3,4-) Ethylendioxythiophen (PEDOT) und/oder Polyanilin (PANI), sind kostengünstig und für eine Anwendung in einem Klettverschluss gut geeignet. Zur Produktion können die Materialien entweder als Fasern gezogen und in einen Klettverschluss eingewoben oder als Oberflächenbeschichtung auf andere Polymere und damit direkt auf die beiden Teile des Klettverschlusses aufgebracht werden.

DE 10 2004 042 397 A1 betrifft eine elektrisch leitfähige textile Kontaktverbindung, umfassend einen ersten und einen zweiten elektrisch leitfähigen textilen Gewebeabschnitt. Hierbei ist eine auf der ersten textilen Oberfläche befestigte oder integrierte erste elektrisch leitfähige Kontaktfläche in lösbarer Verbindung stehend mit einer zweiten textilen Oberfläche und einer auf dieser befestigten oder integrierten zweiten elektrisch leitfähigen Kontaktfläche. Eine textile Applikation ist beispielsweise ein mit einem Textzug bedruckter Stoffstreifen, auf dessen Unterseite Klettflächen, in die Kontaktinseln aus leitfähigem Gewebe integriert sind, vorgesehen sind. Auf der Komplementärseite einer textilen Bahn, wie einem Abschnitt eines Bekleidungsstückes, sind eine Reihe von elektrisch leitfähigen weiteren Kontaktinseln im Klettvlies befestigt. Beim Herstellen der Klettverbindung zwischen den Klettflächen des Stoffstreifens und der Klettvliesen der textilen Bahn wird eine elektrisch leitfähige Verbindung zwischen den Kontaktinseln durch Anpressen von Klettflächen und Klettvliesen hergestellt.

DE 101 05 089 A1 offenbart einen elektrischen Leiter mit einem flachen Querschnitt, der ein elektrisch leitendes Material aufweist, das in ein mit Haken oder Ösen versehenes elektrisch isolierendes Material eingebettet ist. Das elektrisch isolierende Material weist auf zumindest einer Außenseite klettverschlussartige Haken oder Ösen auf. Aufgrund dieser Ausbildung lassen sich derartige elektrische Leiter mittels einer klettverschlussartigen Verbindung an den für sie vorgesehenen Montageflächen, insbesondere an Innenverkleidungen eines Kraftfahrzeuges mit textilartigen Oberflächen, befestigen. Klebeverbindungen werden somit durch haltbare Klettverbindungen ersetzt. Hierbei kann ein gewöhnliches Klettverschlussband als isolierendes Material dienen. Weisen beide Außenseiten des elektrische Leiters Haken und/oder Ösen auf, kann dieser beidseitig an entsprechend ausgebildeten Innenverkleidungen oder Funktionsflächen befestigt werden. Der elektrische Leiter kann ein flexibles Flachbandkabel oder eine flexible gedruckte Schaltung sein.

Als Bestandteil von Haftverschlüssen, wie sie unter der Markenbezeichnung "Kletten" weithin bekannt geworden sind, weisen derartige Haftverschlusselemente eine entsprechende Vielzahl von Haftelementen auf, die mit stielartigen Fußteilen vorzugsweise einstückig mit dem Träger zusammenhängen und kopfseitig Verschlusskörper bilden, die die Form von Pilzköpfen, Haken oder Schlaufen haben können. Dabei sind die Haftelemente mit Stiellängen, die häufig weniger als 1 mm betragen, in einer Musteranordnung mit dichter Packung derart verteilt angeordnet, dass die über den Träger vorstehenden Verhakungskörper in solchen Abständen voneinander angeordnet sind, dass der Verhakungseingriff mit den Gegenelementen eines den Haftverschluss vervollständigenden weiteren Haftverschlusselementes zustande kommt.

Bei der großen Vielfalt der Verwendungs- oder Einsatzmöglichkeiten, bei denen Haftverschlüsse mit Vorteil benutzbar sind, ergeben sich häufig Situationen, bei denen Haftverschlüsse Bestandteil von Systemen sind, die aus synthetischen Materialien aufgebaut sind. Hierbei kann es sich beispielsweise um textile Strukturen mit synthetischen Fasern oder um Tragstrukturen aus Kunststoff oder dergleichen handeln. Bedingt durch die elektrisch isolierenden Eigenschaften derartiger Werkstoffe kommt es unter gewissen Bedingungen zu elektrostatischer Aufladung mit den entsprechenden negativen Auswirkungen, wie Beeinträchtigung des Wohlbefindens handhabender Personen oder Störung elektronischer Systeme durch Entladungen oder elektrische Felder.

Im Hinblick auf diese Problematik stellt sich die Erfindung die Aufgabe, ein Haftverschlusselement zur Verfügung zu stellen, das, obwohl es einen elektrisch nicht leitenden Träger aufweist, den schädlichen Wirkungen elektrischer Potentialbildung entgegenwirkt, und einfach in der Herstellung ist.

Erfindungsgemäß ist diese Aufgabe durch ein Haftverschlusselement gelöst, das die Merkmale des Patentanspruches 1 in seiner Gesamtheit aufweist.

Nach dem kennzeichnenden Teil des Anspruches 1 ist erfindungemäß der Träger in Form eines eine Längsrichtung definierenden Trägerbandes vorgesehen, wobei dieses über zumindest einen Teil seiner Länge von dem mindestens einen Leiterdraht umschlungen ist. Hierbei gestaltet sich die Herstellung besonders einfach durch einen Wickelvorgang.

Innerhalb der Haftfläche des aus elektrisch nicht leitendem Material gebildeten Trägers ist mindestens ein elektrischer Leiter vorgesehen. Trotz eines aus isolierendem Werkstoffen aufgebauten Systems steht daher ein Mittel zur Beeinflussung elektrischer oder elektrostatischer Zustände zur Verfügung, beispielsweise für die Ableitung elektrostatischer Aufladungen.

Bei Gestaltung der Windungen in der Weise, dass ein über das Trägerband durchgehender Leiterdraht in kreuzungsfreien Windungen gewickelt ist, kann eine derartige Wicklung nicht nur mit Vorteil zur Ableitung von elektrostatischen Ladungen dienen, sondern auch einen elektrischen Leiter für einen von einer äußeren Einrichtung her bewirkten Stromfluss bilden, beispielsweise als Steuerleitung für Steuerfunktionen oder als Heizwiderstand. Die Möglichkeit einer Erwärmung oder Beheizung von Haftverschlüssen kann insbesondere vorteilhaft sein, wenn betreffende Haftverschlüsse beispielsweise bei Funktionskleidungen für Personen eingesetzt werden, die klimatisch extremen Bedingungen ausgesetzt sind, wobei es vorteilhaft sein kann, ein Einfrieren von Haftverschlüssen zu vermeiden. Diesbezüglich kann so vorgegangen werden, dass ein entsprechender Leiter mit PTC-Leiterkomponenten versehen ist, die bekanntermaßen eine selbsttätige Temperaturregelung ermöglichen.

In einer bevorzugten Ausführungsform des erfindungsgemäßen Haftverschlusselements ist der mindestens eine Leiterdraht in einer Windungslage kreuzungsfrei durchgehend am Trägerband angeordnet. Weiter ist es vorteilhaft, dass der mindestens eine Leiterdraht von einem Ende zum anderen Ende des Trägerbandes verläuft.

In einer weiteren bevorzugten Ausführungsform des erfindungsgemäßen Haftverschlusselements ist ein Drahtmuster aus sich kreuzenden Drahtabschnitten dadurch gebildet, dass der mindestens eine Leiterdraht um das Trägerband in mindestens zwei Windungslagen geschlungen ist. Ein Drahtmuster aus sich kreuzenden Drahtabschnitten kann dadurch gebildet sein, dass der Leiterdraht um das Trägerband in zwei Windungslagen geschlungen ist, bei denen die Windungslagen in zueinander umgekehrtem Steigungssinne zur Längsachse des Trägerbandes schräg verlaufen. Ein sich derart überkreuzendes Drahtnetz ist insbesondere für den Abbau elektrostatischer Ladungen gut geeignet.

Hierbei kann die Anordnung so getroffen sein, dass die beiden Windungslagen mit zueinander entgegengesetzt gleichen Steigungswinkeln gebildet sind, so dass sich die Drahtabschnitte jeweils mittig an Haftfläche und Rückseite des Trägerbandes kreuzen, so dass ein regelmäßiges Leitermuster gebildet ist.

Um mit einer verhältnismäßig geringen Anzahl von Wickelwindungen einen entsprechenden Längenbereich des Trägerbandes mit Leiterbahnen zu versehen, können mit Vorteil die Windungen an vorderer Haftfläche und an der Rückseite des Trägerbandes zu dessen Längsachse in einem Steigungswinkel verlaufen, der zumindest 10 Winkelgrade beträgt.

Für die Ableitung von Aufladungen ergeben sich besonders günstige Verhältnisse, wenn innerhalb der Haftfläche ein elektrisch leitendes Netzwerk gebildet ist, so dass Leiterbahnen in flächig verteilter Anordnung zur Verfügung stehen.

In vorteilhafter Weise kann hierbei die Anordnung so getroffen sein, dass das Netzwerk mindestens einen Leiterdraht aufweist, der sich in Anlage an Haftelementen entlang der Haftfläche erstreckt. Der Träger ist bevorzugterweise aus einem Kunststoffmaterial gebildet.

Die Anordnung kann mit Vorteil so getroffen sein, dass an der Rückseite des Trägerbandes eine den Leiterdraht überliegende Klebstoffschicht vorhanden ist. Das Haftverschlusselement ist dadurch nicht nur auf besonders einfache Weise am zugeordneten Strukturelement fixierbar, sondern die Klebstoffschicht kann hierbei auch zur Fixierung der Leiterdrahtwindungen dienen oder beitragen.

In entsprechender Weise, wie dies vielfach auch bei Haftverschlusselementen ohne elektrisch leitende Einrichtungen der Fall ist, kann auf der Klebstoffschicht ein Abdeckband vorhanden sein, das für die Anbringung des Haftverschlusselementes an einem betreffenden Strukturelement abziehbar ist.

Nachstehend ist die Erfindung anhand eines in der Zeichnung dargestellten Ausführungsbeispieles im Einzelnen erläutert. Es zeigen:
- Fig. 1: eine stark vereinfachte, lediglich in Form einer Funktionsskizze gezeichnete Darstellung zur Verdeutlichung des Herstellvorganges für ein Ausführungsbeispiel des erfindungsgemäßen Haftverschlusselementes und
- Fig. 2: eine gegenüber einer praktischen Ausführungsform etwa in doppeltem Maßstab gezeichnete, perspektivische Schrägansicht des Ausführungsbeispieles des Haftverschlusselementes, wobei Haftelemente lediglich schematisiert angedeutet sind und ein Abdeckband teilweise abgezogen dargestellt ist.

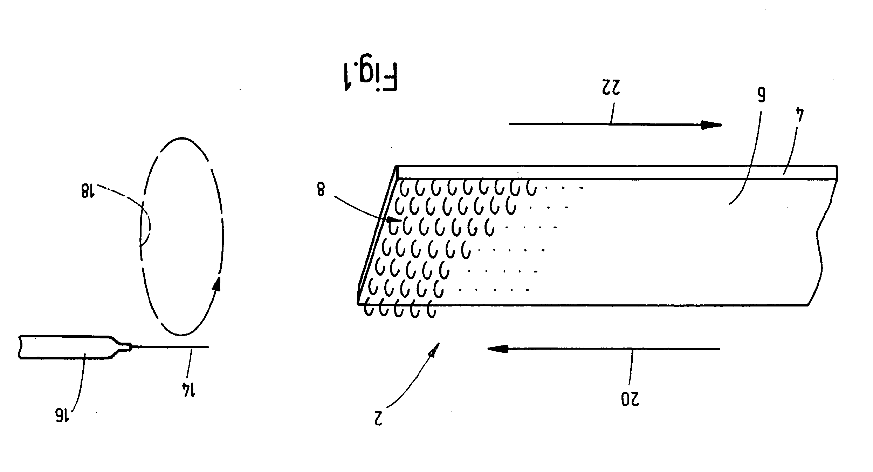

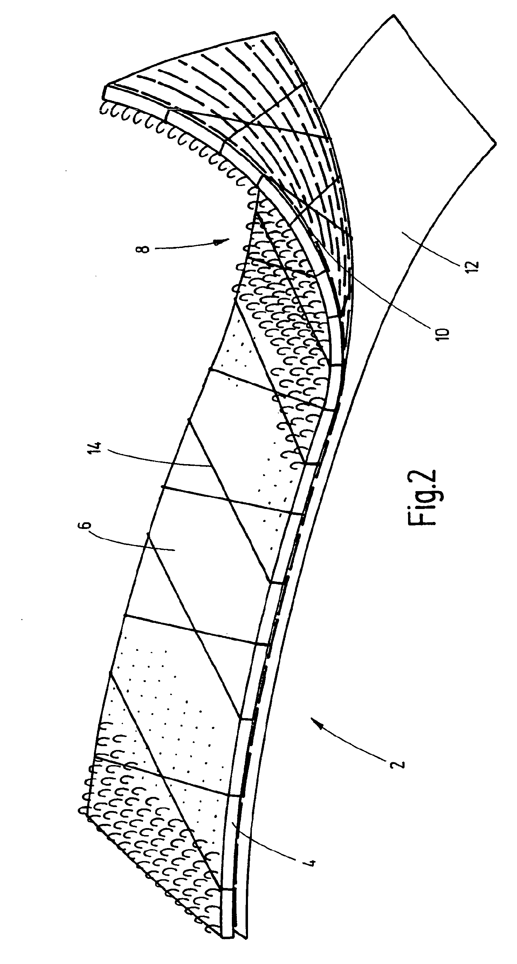

In der Zeichnung ist ein Ausführungsbeispiel des erfindungsgemäßen Haftverschlusselementes als Ganzes mit 2 bezeichnet, wobei in Fig. 1 lediglich ein Teillängenabschnitt dargestellt ist. Wie Fig. 2 zeigt, ist das Haftverschlusselement 2 mehrlagig aufgebaut, mit einem Trägerband 4 aus einem gut spritzbaren Kunststoffmaterial, aus dessen Haftfläche 6 Haftelemente 8 vorspringen, die lediglich schematisch vereinfacht, teilweise in Häkchenform angedeutet sind. In der bei derartigen Haftverschlusselementen 2 an sich bekannter Weise weisen die Haftelemente 8 stielartige, mit dem Trägerband 4 zusammenhängende Fußteile auf und bilden kopfseitig Verhakungskörper, beispielsweise in Form von Pilzköpfen, Haken oder Schlaufen. In der bei derartigen Kunststoff-Haftverschlusselementen üblichen Weise können die Haftelemente 8 feinstrukturiert mit einem Überstand von weniger als 1 mm über die Haftfläche 6 und mit einer Packungsdichte von mehreren 100/cm² ausgebildet sein. Wie Fig. 2 zeigt, ist auf der der Haftfläche 6 gegenüberliegenden Rückseite des Trägerbandes 4 eine Klebstoffschicht 10 aufgetragen, die durch ein Abdeckband 12 bedeckt ist, das aus einem Material gebildet ist, das von der Klebstoffschicht 10 leicht abziehbar ist, wenn das Haftverschlusselement 2 an ein betreffendes Strukturelement angeklebt werden soll.

Bei dem vorliegenden Ausführungsbeispiel ist, wie in Fig. 2 dargestellt, ein dünner Leiterdraht 14 um das Haftverschlusselement 2 so herum gelegt, dass er sich mit geraden Windungsabschnitten über die Haftfläche 6 und über die Rückseite des Trägerbandes 4 erstreckt, wobei die Windungsabschnitte an der Haftfläche 6 sich teilweise durch Zwischenräume zwischen Haftelementen 8 erstrecken. Beim gezeigten Beispiel sind zwei Windungslagen vorgesehen, wobei der Steigungswinkel gegenüber der Längsrichtung des Trägerbandes 4 mehrere Winkelgrad beträgt, so dass sich für die Windungsabschnitte an der Haftfläche 6 und an der Rückseite jeweils ein größerer Abstand ergibt, wie dies in Fig. 2 gezeigt ist. Dabei erstrecken sich die Windungsabschnitte der Windungslagen so, dass die Windungsabschnitte der einen Windungslage gegenüber der Längsrichtung des Trägerbandes 4 nach der einen Seite geneigt sind, während die Windungsabschnitte der zweiten Windungslage eine entgegengesetzte Neigung zur Längsrichtung besitzen. Die Steigungswinkel sind jeweils zueinander entgegengesetzt gleich groß gewählt, so dass sich die Windungsabschnitte jeweils im Trägerband 4 mittig kreuzen. Somit ist ein leitendes Netzwerk gebildet, bei dem die Windungsabschnitte ein Leitermuster mit in der Draufsicht X-förmigem Leiterverlauf bilden.

Bei der Herstellung durch einen Wickelvorgang kann so vorgegangen werden, wie dies in Fig. 1 schematisiert angedeutet ist. Um einen Trägerbandabschnitt, wie er in Fig. 2 gezeigt ist, zu bewirken, kann eine Drahtabgabeeinheit 16 vorgesehen sein, die den austretenden Draht 14 in kreisförmigen, mit Drehpfeil 18 angedeuteten Wickelbewegungen führt, so dass, wenn der zu bewickelnde Abschnitt des Trägerbandes 4 in der in Fig. 1 mit Richtungspfeil 20 angedeuteten Richtung bewegt wird, die gesamte Länge des in Fig. 2 gezeigten Abschnittes des Trägerbandes 4 gewickelt wird. Wenn nur eine Windungslage gebildet werden soll, so dass sich, ohne eine X-Form zu bilden, der Leiterdraht 14 kreuzungsfrei über die Länge des Trägerbandes 4 erstreckt, wobei die Windungsabschnitte an Haftfläche 6 und an Rückseite jeweils zueinander parallel und in gleichem Steigungssinne verlaufend erstrecken, wird der Wickelvorgang beendet. Wenn jedoch die in Fig. 2 gezeigte zweite Windungslage zur X-förmigen Kreuzungsbildung gewickelt werden soll, wird der Wickelvorgang nunmehr bei der Rückbewegung entsprechend dem Richtungspfeil 22 fortgesetzt.

In beiden Fällen erfolgt die Kontaktierung der auf dem Trägerband 4 gebildeten Leiteranordnung vorzugsweise am einen und/oder anderen Ende der Windung und/oder Windungen. Diese Art der Kontaktierung gestaltet sich insofern einfacher als beispielsweise an der Rückseite des Trägerbandes 4, weil bei an der Rückseite des Trägerbandes 4 nach Durchführen des Wickelvorgangs aufgebrachter Klebstoffschicht 10 die Windungsabschnitte mehr oder weniger in die Klebstoffschicht eingebettet und für Kontaktierungszwecke weniger gut freiliegend sind. Das Einbetten der Windungsabschnitte in die Klebstoffschicht 10 führt in vorteilhafter Weise auch zu einer Fixierung der Windungen.

Wenn der Leiterdraht 14 bei einem betreffenden Ausführungsbeispiel nicht in erster Linie zum Abführen elektrostatischer Ladungen dienen soll, sondern stattdessen oder zusätzlich als stromführender Leiter für Steuer- oder Heizzwecke oder dergleichen dienen soll, ist vorzugsweise lediglich eine von einem Ende zum anderen Ende des Trägerbandes 4 kreuzungsfrei durchgehende Windungslage des Leiterdrahtes 14 vorgesehen. Wenn andererseits in erster Linie elektrostatische Aufladungen abzuführen sind, ist ein Windungsmuster, wie in Fig. 2 gezeigt, mit X-förmiger Überkreuzung der Leiterdrähte 14 besonders vorteilhaft.

Vorzugsweise wird bei der Bildung des Windungsmusters ein feiner Leiterdraht benutzt und der Wickelvorgang derart gestaltet, dass sich der Leiterdraht 14 an der Haftfläche 6 des Trägerbandes 4 bündig anliegend entlang der Stiele der Haftelemente 8 erstreckt, so dass die Haftelemente 8 in ihrem Kopfbereich frei bleiben und die Verhakungskörper in Form von Pilzköpfen, Haken oder Schlaufen, oder auch in Form einer Mischung aus Verhakungskörpern in Form von Schlaufen, Haken und Pilzköpfen, für den Verhakungseingriff mit den Haftelementen des Gegenelementes vom Leiterdraht 14 frei und unbehindert sind. Die Windungslagen sind somit nicht nur an der Rückseite des Trägerbandes 4 durch die Klebstoffschicht 10 gegen Verrutschen gesichert, sondern auch an der Haftfläche 6 durch den Verlauf in den Zwischenräumen zwischen Stielen der Haftelemente 8 gegen Verrutschen gesichert.

## Patentansprüche

1. Haftverschlusselement mit einem elektrisch nicht leitenden Träger (4), der eine Haftfläche (6) definiert, aus der sich Haftelemente (8) erstrecken, die für die Bildung eines Haftverschlusses mit Gegenelementen verhakbar sind, wobei innerhalb der Haftfläche (6) mindestens ein elektrischer Leiterdraht (14) vorhanden ist, **dadurch gekennzeichnet, dass** der Träger in Form eines eine Längsrichtung definierenden Trägerbandes (4) vorgesehen ist, und dass dieses über zumindest einen Teil seiner Länge von dem mindestens einen Leiterdraht (14) umschlungen ist.

2. Haftverschlusselement nach Anspruch 1, **dadurch gekennzeichnet, dass** der mindestens eine Leiterdraht (14) in einer Windungslage kreuzungsfrei durchgehend am Trägerband (4) angeordnet ist.

3. Haftverschlusselement nach Anspruch 1 oder 2, **dadurch gekennzeichnet, dass** der mindestens eine Leiterdraht (14) von einem Ende zum anderen Ende des Trägerbands (4) verläuft.

4. Haftverschlusselement nach Anspruch 1, **dadurch gekennzeichnet**, ein Drahtmuster aus sich kreuzenden Drahtabschnitten dadurch gebildet ist, dass der mindestens eine Leiterdraht (14) um das Trägerband (4) in mindestens zwei Windungslagen geschlungen ist.

5. Haftverschlusselement nach Anspruch 4, **dadurch gekennzeichnet, dass** die Windungslagen in zueinander umgekehrtem Steigungssinne zur Längsachse des Trägerbandes (4) schräg verlaufen.

6. Haftverschlusselement nach Anspruch 5, **dadurch gekennzeichnet, dass** die beiden Windungslagen mit zueinander entgegengesetzt gleichen Steigungswinkeln gewickelt sind, so dass sich die Drahtabschnitte jeweils mittig an Haftfläche (6) und Rückseite des Trägerbandes (4) kreuzen.

7. Haftverschlusselement nach einem der Ansprüche 2 bis 6, **dadurch gekennzeichnet, dass** die Windungen an vorderer Haftfläche (6) und an der Rückseite des Trägerbandes (4) zur Längsachse in einem Steigungswinkel verlaufen, der zumindest zehn Winkelgrad beträgt.

8. Haftverschlusselement nach einem der Ansprüche 4 bis 7, **dadurch gekennzeichnet, dass** innerhalb der Haftfläche (6) ein elektrisch leitendes Netzwerk (14) gebildet ist.

9. Haftverschlusselement nach einem der vorhergehenden Ansprüche, **dadurch gekennzeichnet, dass** sich der mindestens eine Leiterdraht (14) in Anlage an Haftelementen (8) entlang der Haftfläche (6) erstreckt.

10. Haftverschl usselement nach einem der vorhergehenden Ansprüche, **dadurch gekennzeichnet, dass** der Träger (4) aus einem Kunststoffmaterial gebildet ist.

11. Haftverschlusselement nach einem der vorhergehenden Ansprüche, **dadurch gekennzeichnet, dass** an der Rückseite des Trägerbandes (4) eine den mindestens einen Leiterdraht (14) überliegende Klebstoffschicht (10) vorhanden ist.

12. Haftverschlusselement nach Anspruch 11, **dadurch gekennzeichnet, dass** auf der Klebstoffschicht (10) ein zur Anbringung des Haftverschlusselementes (2) an einem Strukturelement abziehbares Abdeckband (12) vorhanden ist.

## Claims

1. A hook and loop fastener element with an electrically non-conductive substrate (4) which defines an adhesive area (6) from which extend adhesive elements (8) that can interlock with counter-elements in order to form a hook and loop fastener, at least one electrical conductor wire (14) being present inside the adhesive area, **characterised in that** the substrate is provided in the form of a substrate tape (4) defining a longitudinal direction, and that said substrate tape is wrapped over at least part of its length by the at least one conductor wire (14).

2. The hook and loop fastener element according to Claim 1, **characterised in that** the at least one conductor wire (14) in a winding layer is arranged without crossing in a continuous manner on the substrate tape (4).

3. The hook and loop fastener element according to Claim 1 or 2, **characterised in that** the at least one conductor wire (14) runs from one end to the other end of the substrate tape (4).

4. The hook and loop fastener element according to Claim 1, **characterised in that** a wire pattern of crossing wire sections is formed by wrapping the at least one conductor wire (14) around the substrate tape (4) in at least two winding layers.

5. The hook and loop fastener element according to Claim 4, **characterised in that** the winding layers slope toward the longitudinal axis of the substrate tape (4) in the direction of pitch reversed to each other.

6. The hook and loop fastener element according to Claim 5, **characterised in that** both winding layers are formed at mutually opposite, identical pitch angles so that in each case the wire sections cross one another centrally on the adhesive area (6) and the rear side of the substrate tape (4).

7. The hook and loop fastener element according to any of Claims 2 to 6, **characterised in that** the windings on the front adhesive area (6) and on the rear side of the substrate tape (4) run relative to the longitudinal axis at a pitch angle that is at least ten angular degrees.

8. The hook and loop fastener element according to any of Claims 4 to 7, **characterised in that** an electrically conductive network (14) is formed inside the adhesive area (6).

9. The hook and loop fastener element according to any of the preceding claims, **characterised in that** the at least one conductor wire (14) extends along the adhesive area (6) in contact with adhesive elements (8).

10. The hook and loop fastener element according to any of the preceding claims, **characterised in that** the substrate (4) is made of a plastic material.

11. The hook and loop fastener element according to any of the preceding claims, **characterised in that** the rear side of the substrate tape (4) has a layer of adhesive (10) that is superposed on at least one conductor wire (14).

12. The hook and loop fastener element according to Claim 11, **characterised in that** the layer of adhesive (10) has a cover strip (12) which can be peeled off in order to attach the hook and loop fastener element (2) to a structural element.

## Revendications

1. Elément de fermeture auto-agrippante, comprenant un support (4), qui n'est pas conducteur de l'électricité et qui définit une surface (6) d'accrochage, à partir de laquelle s'étendent des éléments (8) d'accrochage, qui, pour la formation d'une fermeture auto-agrippante, peuvent être accrochés par des éléments antagonistes, au moins un fil (14) conducteur de l'électricité étant présent au sein de la surface (6) d'accrochage, **caractérisé en ce que** le support est prévu sous la forme d'un ruban (4) de support définissant une direction longitudinale et **en ce que** ce ruban est, sur au moins une partie de sa longueur, entortillé par le au moins un fil (14) conducteur.

2. Fermeture auto-agrippante suivant la revendication 1, **caractérisé en ce que** le au moins un fil (14) conducteur est disposé sur le ruban (4) de support de bout en bout sans croisement en une couche de spires.

3. Fermeture auto-agrippante suivant la revendication 1 ou 2, **caractérisé en ce que** le au moins un fil (14) conducteur s'étend d'une extrémité à l'autre du ruban (4) de support.

4. Fermeture auto-agrippante suivant la revendication 1, **caractérisé en ce qu'**un motif de fil, composé de tronçons de fil qui s'entrecroisent, est formé par le fait que le au moins un fil (14) conducteur est entortillé autour du ruban (4) de support en au moins deux couches de spires.

5. Fermeture auto-agrippante suivant la revendication 4, **caractérisé en ce que** les couches de spires sont inclinées sur l'axe longitudinal du ruban (4) de support en des sens de pentes inversées l'une par rapport à l'autre.

6. Fermeture auto-agrippante suivant la revendication 5, **caractérisé en ce que** les deux couches de spires sont enroulées en ayant des angles de pentes égaux opposés l'un à l'autre, de sorte que les tronçons de fil s'entrecroisent respectivement au milieu sur la surface (6) d'accrochage et sur la face arrière du ruban (4) de support.

7. Fermeture auto-agrippante suivant l'une des revendications 2 à 6, **caractérisé en ce que** les spires s'étendent sur la surface (6) d'accrochage avant et sur la face arrière du ruban (4) de support, en faisant avec l'axe longitudinal un angle de pente qui est d'au moins de 10 degrés.

8. Fermeture auto-agrippante suivant l'une des revendications 4 à 7, **caractérisé en ce qu'**un réseau (14) conducteur de l'électricité est formé au sein de la surface (6) d'accrochage.

9. Fermeture auto-agrippante suivant l'une des revendications précédentes, **caractérisé en ce que** le au moins un fil (14) conducteur s'étend le long de la surface (6) d'accrochage, en étant mis sur des éléments (8) d'accrochage.

10. Fermeture auto-agrippante suivant l'une des revendications précédentes, **caractérisé en ce que** le support (4) est en une matière plastique.

11. Fermeture auto-agrippante suivant l'une des revendications précédentes, **caractérisé en ce qu'**une couche (10) de colle recouvrant le au moins un fil (4) conducteur est présente sur la face arrière du ruban (4) de support.

12. Fermeture auto-agrippante suivant la revendication 11, **caractérisé en ce qu'**il y a sur la couche (10) de colle un ruban (12) de recouvrement, pouvant être retiré pour mettre l'élément (2) de fermeture auto-agrippante sur un élément de structure.
